Europäisches Patentamt

European Patent Office

Office européen des brevets

(11) Publication number : **0 025 670**
**B2**

(12) NEW EUROPEAN PATENT SPECIFICATION

(45) Date of publication of the new patent specification :
05.04.89

(21) Application number : 80303093.1

(22) Date of filing : 04.09.80

(51) Int. Cl.⁴ : **C 30 B 31/22,** H 01 L 21/265,
C 23 C 14/48

(54) Method and apparatus for conducting heat to or from an article being treated under vacuum.

(30) Priority : 14.09.79 US 75401

(43) Date of publication of application :
25.03.81 Bulletin 81/12

(45) Publication of the grant of the patent :
25.01.84 Bulletin 84/04

(45) Mention of the opposition decision :
05.04.89 Bulletin 89/14

(84) Designated contracting states :
DE FR GB IT SE

(56) References cited :
US--A-- 3 566 960
IBM TECHNICAL DISCLOSURE BULLETIN vol. 21, no.
2, July 1978, New York US, J.J. CUOMO: "Heat
transfer process for high thermal input processes"
pages 840-841
JAPANESE JOURNAL OF APPLIED PHYSICS, vol. 18,
supplement 18-1 1979, Y. WADA et al.: "Application of
High Current Arsenic Ion Implantation to Dynamic
MOS Memory LSI's" pages 247-254
Dr.Ing.G.Ogiermann: "Wärmebehandlung metallis-
cher Werkstoffe im Vakuum", Härterei-Technische
Mitteilungen, Jhrg. 20, Heft 3, pp. 180-186
C.H. Luiten, E. Kria: "Wärmebehandlung im
Vakuum", VDI-Zeitschrift 118 (1976), Nr. 22, pp. 1073-
1079
F.W. Eysell, E. Heumüller: "Entwicklungstendenzen
auf dem Gebiet der Unterdruckaufkohlung", Härte-
rei-Technische Mitteilungen 34 (1979) 2, pp. 83-90

(73) Proprietor : **EATON CORPORATION**
**100 Erieview Plaza**
**Cleveland Ohio 44114 (US)**

(72) Inventor : **King, Monroe Lee**
**10013 Woodland Drive**
**Austin Texas (US)**

(74) Representative : **Slight, Geoffrey Charles et al**
**Graham Watt & Co. Riverhead**
**Sevenoaks Kent TN13 2BN (GB)**

## Description

The present invention relates to a method of and apparatus for treating an article in a vacuum chamber.

In many applications where articles are treated within a vacuum chamber it is desirable to control the temperature of the article. One such application is ion implantation of semi conductor wafers wherein a high energy ion beam is directed onto a semi conductor wafer which also results in heating of the wafer. Heating of the wafer in any ion implant process has a number of undesirable effects including damage to a photoresist layer thereon which can out gas and shrink thereby destroying the desired precise pattern intended on the wafer by use of the photoresist. Prior art implantation systems rely upon heat removal from the silicon wafer by radiation effect only. Absence of gas molecules in the vacuum system such as typically $7 \times 10^{-7}$ Torr ($9.333 \times 10^{-11}$ N/mm²) virtually eliminates conductive paths for heat flow. As beam powers in ion implantation systems have increased, radiation cooling alone is no longer sufficient, and there have been attempts to make intimate contact with the silicon wafer for increased conduction of heat. One method that has been attempted is the use of a thermally conductive conformat (soft pliable material) pressed mechanically to the back of the silicon slice hopefully to establish as many as possible point contacts between the wafer and the conformat for conduction of heat to support member. Although significant temperature depression has been realised with the use of a conformat, problems of repeatability, thermal non-uniformity and expensive maintenance have been experienced.

The present invention provides a method of treating an article in a vacuum chamber under subatmospheric pressure including steps of positioning the article on a support at a treatment station within the vacuum chamber and providing a gas between the article and the support which conducts heat between the article and the support.

The method of the present invention is characterized by controlling the temperature of the article during the treatment by introducing said heat conducting gas directly between the article and the support at a predetermined pressure higher than the subatmospheric pressure in the vacuum chamber whilst clamping the article to the support to limit the excess flow of gas and produce a small path length for thermal conduction.

The heat conducting gas provides sufficient conductivity to allow the required temperature control of the article during its treatment.

The characteristic of thermal conductivity of a gas versus pressure is relatively flat from a pressure of approximately 3,000 psi (20.67 N/mm²) to 5/760 of an atmosphere (666.62 N/m²), at which level the thermal conductivity of the gas decays rapidly. Experimentation has shown that gas between a silicon wafer and a flat plate in the pressure range of 0.5 to 2.0 Torr (66.661 to 266.644 N/m²) has a very low diffusion rate into the void of a surrounding vacuum system while at the same time providing sufficient thermal conductivity to maintain the temperature of the wafer at appropriate levels during ion implantation.

The present invention also comprehends an apparatus for handling and treating articles under vacuum by a method of the present invention comprising a vacuum chamber, an inlet station, a treatment station, an outlet station, a support having a substantially flat mounting surface on which an article is to be clamped at the treatment station, a source of pressurized gas, regulating means for controlling the pressure of gas supplied from said source and conduit means connected to said source and opening at an orifice in said flat mounting surface of said support for introducing the gas under controlled pressure directly between an article clamped at the treatment station and the support for conducting heat between the article and the support.

One way of carrying out the present invention in both its method and apparatus aspects will now be described by way of example and not by way of limitation with reference to drawings wherein similar characters of references refer to similar structural elements in each of the several views.

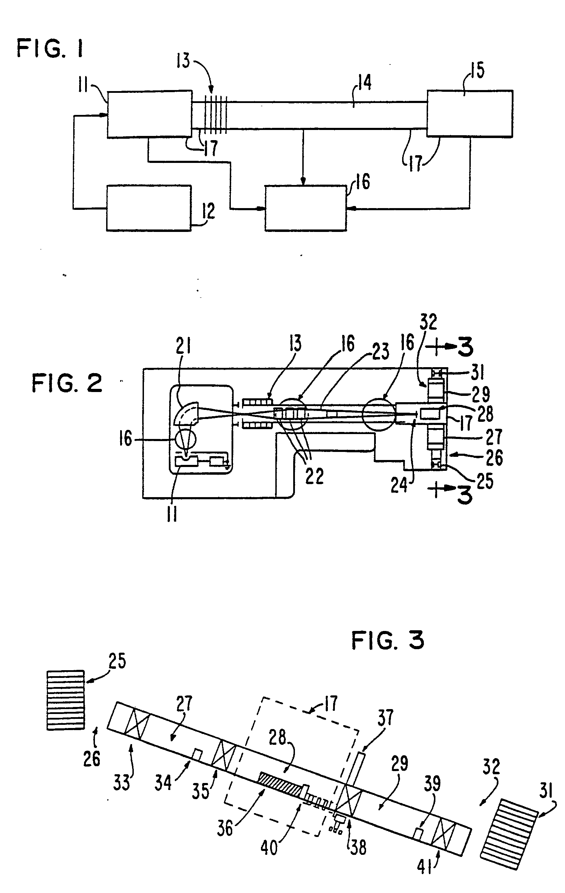

In the drawings, Figure 1 is a schematic block diagram illustrating one application of the present invention.

Figure 2 is a schematic plan view of an ion implantation system incorporating the present invention.

Figure 3 is a schematic elevational sectional view of a portion of the structure shown in Figure 2 taken along line 3-3 in the direction of the arrows.

Figure 4 is a schematic elevational view, partially broken away, illustrating a portion of the structure shown in Figure 3.

Figure 5 is a graph showing thermal conductance plotted versus gas pressure for nitrogen gas.

Figure 6 is a graph of temperature plotted versus ion beam power showing for the temperature of a silicon wafer in an ion implantation system both for an uncooled wafer and a wafer cooled in accordance with the present invention with nitrogen gas at two different pressure levels.

While the present invention is applicable to provide thermal conductivity for controlling the temperature of an article in a vacuum for numerous possible applications, it is especially applicable for cooling a semiconductor wafer in an ion implantation system. Accordingly the way of carrying out the invention which is now to be described with reference to the drawings will relate to such an ion implantation system.

Referring now to the drawings, particularly with reference to Figures 1 and 2, there is schematically illustrated an ion implantation system wherein ions from a source 11 connected to a high voltage power supply 12 are generated for projection through an accelerator column 13 along a beam line 14 to an end station 15 wherein the ions are directed against a semiconductor wafer. The source 11 column 13, beam line 14, and end station 15 contained within a vacuum envelope 17 are maintained under high vacuum by vacuum pumping devices 16. The ion implantation system is typically operated at about the level $7 \times 10^{-7}$ Torr ($9.333 \times 10^{-11}$ N/mm$^2$) when the ion beam is directed against the wafer.

Figure 2 better illustrates the elements of the ion implantation system. Ions from the source 11 are redirected by an analysing magnet 21 before being directed through the accelerator column 13 and after which pass through a triplet quadruple lens 22 and scanners 23. At the end station 15 wafers 24 from an input cassette 25 are directed to an inlet station 26 through a vacuum lock 27 and into the high vacuum chamber 17 to the treatment station 28 where the wafer 24 is exposed to the ion beam. From the treatment station the wafer passes through a vacuum lock 29 to an output cassette 31 at the outlet station 32.

Figure 3 schematically illustrates the structure and movement of the wafer from the input cassette 25 to the output cassette 31. As shown in Figure 3 the wafer from cassette 25 passes through a first gate valve 33 to a wafer stop 34 at which time the gate valve 33 is closed and the vacuum lock 27 reduced to an intermediate vacuum pressure. Then a second gate valve 35 is opened and the wafer fed by gravity onto a target block or support in the form of a plate member 36 at a stop 40 at the treatment station 28. The wafer is clamped to a substantially flat surface of the target block 36 which is then tilted by a swing arm 37 for application of the appropriate ion dosage. The target block 36 is then swung down so that the wafer is released from the clamp and moves by gravity on through the third open gate valve 38 to a stop 39 in vacuum lock 29. Gate valve 38 is then closed and a fourth gate valve 41 opened whereby the wafer is fed by gravity to the output cassette 31.

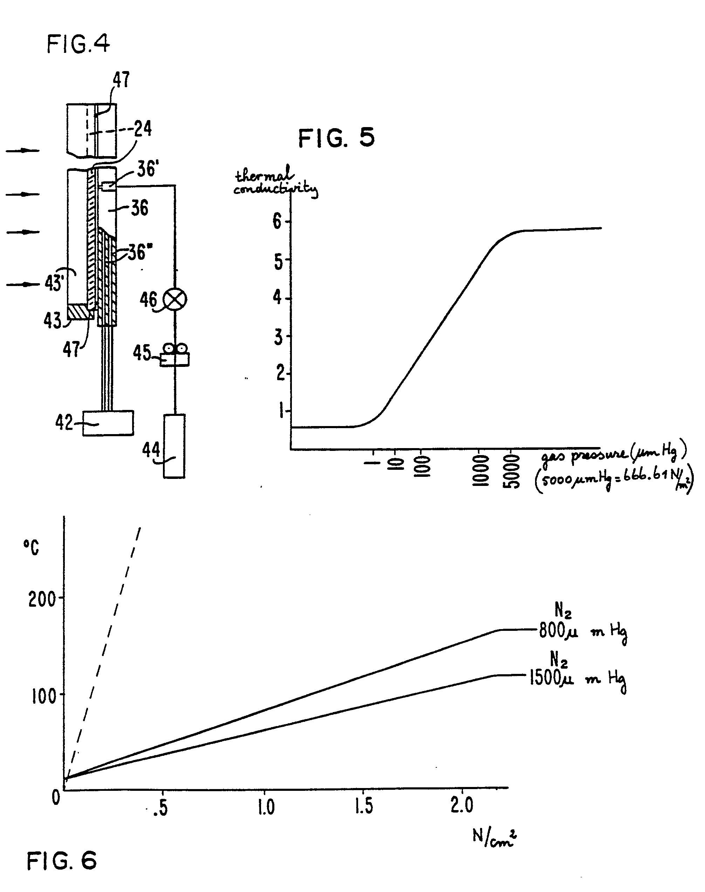

Figure 4 schematically illustrates the positioning and clamping of the wafer 24 on the target block 36 which may be cooled via a cooling system such as freon circulated through internal passageways 36″ from a coolant recirculation system 42. The wafer 24 is clamped to the substantially flat surface of the target block 36 by a clamp 43 that is centrally apertured at 43′ to pass the ion beam and that engages the wafer 24 adjacent its periphery.

Gas under pressure of 0.5 to 2.0 Torr (66.661 to 266.644 N/m$^2$) is fed through a channel 36′ to the interface between the wafer 24 and the target block 36 and provides the thermal conductivity for transferring heat from the wafer to the cooled target block. A gas with a high thermal conductivity such as nitrogen, neon, helium or hydrogen (which are arranged in ascending order of conductivity at 360 °K) is directed from a source 44 through a regulator 45 and leak valve 46 to the channel 36′. It has been found that an orifice at the end of the channel 36′ of approximately 10 to 20 thousandths of an inch (0.254 to 0.508 mm) diameter is sufficient to provide the appropriate gas for maintaining a 3″ (7.62 cm) wafer 24 at the desired temperature.

Figure 5 shows a graph of thermal conductivity plotted versus gas pressure for nitrogen gas. It will be seen that the thermal conductivity remains high for gas pressures down to approximately 5 000 μm Hg (666.61 N/m$^2$) where it begins to fall off dramatically. Use of gas at a pressure in the range of 0.5 to 2.0 Torr (66.661 to 266.644 N/m$^2$) provides the appropriate thermal conductivity for conducting heat away from the wafer. Figure 6 shows a graph plotting temperature of a wafer against ion beam power and shows the effectiveness of the use of nitrogen gas at a pressure of 800 μm Hg (106.658 N/m$^2$) and 1 500 μm Hg (199.983 N/m$^2$).

While it has not been found essential for successful utilisation of the present invention, a seal may be provided between the wafer 24 and the target block 36 adjacent the periphery of wafer 24 by an « O » ring 47.

It will be appreciated by those skilled in the art that selection of the particular operating gas and gas pressure will depend upon the efficiency and nature of the particular system operation.

Additionally, it will be appreciated by those skilled in the art that this invention can be utilised for temperature control of articles such as wafers in other vacuum treatment processes, for example, plasma etching of semiconductor wafers in a planar etching system, well known in the art, ion beam milling and electron beam annealing, and that the method of the invention can be used for ensuring adequate heating of an article in a vacuum treatment process by conduction of heat from a heated plate against which the article is clamped, as well as for ensuring adequate cooling of an article being treated.

**Claims**

1. A method of treating an article in a vacuum chamber under subatmospheric pressure including steps of positioning the article on a support (36) at a treatment station (28) within the vacuum chamber and providing a gas between the article and the support which conducts heat between the article and the support characterized by controlling the temperature of the article during the treatment by introducing said heat conducting gas directly between the article and the support at a predetermined pressure higher than the subatmospheric pressure in the vacuum chamber whilst clamping the article to the support to limit the excess flow of gas and produce a small path length for thermal conduction.

2. A method as claimed in claim 1, wherein said heat conducting gas is provided between the article and the support at a pressure of 0.5 to 2.0 Torr (66.661-266.644 N/m$^2$).

3. A method as claimed in claim 1 or 2, for the ion implantation of a semi conductor wafer the method including the steps of directing an ion beam on the wafer at the treatment station for ion implantation into the wafer and conducting heat from the wafer to the support via said heat conducting gas.

4. A method as claimed in claim 1, 2 or 3, including the step of cooling the support thereby to cool the article being treated by conduction of heat from the article to the support via said heat conducting gas.

5. An apparatus for handling and treating articles under vacuum by a method as claimed in claim 1 or 2, comprising a vacuum chamber (17), an inlet station (26), a treatment station (28), an outlet station (32), a support (36) having a substantially flat mounting surface on which an article is to be clamped at the treatment station, a source (44, 45) of pressurized gas, regulating means (45) for controlling the pressure of gas supplied from said source and conduit means (36') connected to said source and opening at an orifice in said flat mounting surface of said support for introducing the gas under controlled pressure directly between an article clamped at the treatment station and the support (36) for conducting heat between the article and the support.

6. An apparatus as claimed in claim 5, including a seal (47) for sealing an article to be treated to the support (36) adjacent the periphery of the article with the article positioned over said orifice.

7. An apparatus as claimed in claim 5 or 6, for treating a semi conductor wafer to implantations therein by a method as claimed in claim 3, the apparatus including an ion source (11), and an ion accelerator column (13) for directing an ion beam on a wafer at the treatment station.

8. An apparatus as claimed in any one of claims 5 to 7 for treating an article under vacuum by a method as claimed in claim 4, including a coolant system (36", 42) for cooling the support (36).

9. An apparatus as claimed in claim 7, including means for controlling the temperature of said mounting surface, a centrally apertured clamp (43) for engaging one flat surface of said semi conductor wafer at its periphery to clamp the other flat surface of said wafer against said mounting surface, said ion accelerator column being directed through the aperture (43') of said clamp to said one surface of said wafer.

10. An apparatus as claimed in claim 9 including means for gravity feeding the wafer from a first position to the treatment station (28) and onto said flat surface of said support (36), and means enabling the wafer to slide off of said support (36) to a further position.

11. An apparatus as claimed in claim 10 wherein said support (36) is tiltable from its wafer receiving position to a position where it intercepts the line of said ion beam (14).

**Patentansprüche**

1. Verfahren zur Behandlung eines Gegenstandes in einer Vakuumkammer unter subatmosphärischem Druck unter Verwendung folgender Schritte : Positionierung des Gegenstandes auf einem Träger (36) an einer Behandlungsstation (28) innerhalb der Vakuumkammer und Vorsehen eines Gases zwischen dem Gegenstand und dem Träger, welches Wärme zwischen dem Gegenstand und dem Träger leitet, gekennzeichnet durch die Steuerung der Temperatur des Gegenstandes während der Behandlung durch Einführung des wärmeleitenden Gases direkt zwischen dem Gegenstand und dem Träger mit einem vorbestimmten Druck, der höher ist als der subatmosphärische Druck in der Vakuumkammer, während der Gegenstand an den Träger geklemmt ist, um Überschußgasfluß zu begrenzen und eine kleine Bahnlänge für die thermische Leitung zu erzeugen.

2. Verfahren nach Anspruch 1, wobei das wärmeleitende Gas zwischen dem Gegenstand und dem Träger mit einem Druck von 0,5 bis 2,0 Torr (66,661 bis 266,644 N/m$^2$) vorgesehen ist.

3. Verfahren nach Anspruch 1 oder 2 für die Ionenimplantation eines Halbleiter-Wafers, wobei das Verfahren folgende Schritte aufweist : Leiten eines Ionenstrahls auf das Wafer an der Behandlungsstation zur Ionenimplantation im Wafer und zur Leitung von Wärme vom Wafer zum Träger über das wärmeleitende Gas.

4. Verfahren nach Anspruch 1, 2 oder 3 einschließich des Schrittes des Kühlens des Trägers, um dadurch den behandelten Gegenstand zu kühlen und zwar durch Wärmeleitung vom Gegenstand zum Träger über das wärmeleitende Gas.

5. Vorrichtung zur Handhabung und Behandlung von Gegenständen unter Vakuum durch ein Verfahren nach Anspruch 1 oder 2, wobei folgendes vorgesehen ist : eine Vakuumkammer (17), eine Einlaßstation (26), eine Behandlungsstation (28), eine Auslaßstation (32), ein Träger (36) mit einer im wesentlichen flachen Befestigungsoberfläche, auf der der Gegenstand an der Behandlungsstation festzuklemmen ist, eine Quelle (44, 45) von unter Druck stehendem Gas, Reguliermittel (45) zur Steuerung des Drucks des von der Quelle gelieferten Gases und Leitungsmittel (36') verbunden mit der Quelle und sich öffnend an einer Zumeßöffnung in der flachen Befestigungsoberfläche des Trägers zum Einführen des Gases unter gesteuertem Druck direkt zwischen dem an der Behandlungsstation festgeklemmten Gegenstand und dem Träger (36), um Wärme zwischen Gegenstand und Träger zu leiten.

6. Vorrichtung nach Anspruch 5 mit einer Dichtung (47) zum Abdichten eines zu behandelnden Gegenstandes am Träger benachbart zum Umfang des Gegenstandes, wobei der Gegenstand über der Zumeßöffnung positioniert ist.

7. Vorrichtung nach Anspruch 5 oder 6 zur Behandlung eines Halbleiter-Wafers mit Implantationen darin, durch ein Verfahren nach Anspruch 3, wobei die Vorrichtung eine Ionenquelle (11) und eine Ionenbeschleunigssäule (13) aufweist, um einen Ionenstrahl auf ein Wafer an der Behandlungsstation zu leiten.

8. Vorrichtung nach einem der Ansprüche 5 bis 7 zur Behandlung eines Gegenstandes unter Vakuum durch ein Verfahren nach Anspruch 4 mit einem Kühlsystem (36", 42) zum Kühlen des Trägers (36).

9. Vorrichtung nach Anspruch 7 mit Mitteln zur Steuerung der Temperatur der Befestigungsoberfläche, einer mittig mit Öffnung versehenen Klammer (43) zum Erfassen einer flachen Oberfläche des Halbleiter-Wafers an seinem Umfang, um die andere flache Oberfläche des Wafers gegen die Befestigungsoberfläche zu klemmen, wobei die Ionenbeschleunigungssäule durch die Öffnung (43') der Klammer zu der erwähnten einen Oberfläche des Wafers gerichtet ist.

10. Vorrichtung nach Anspruch 9 mit Mitteln zur Schwerkrafteingabe des Wafers von einer ersten Position zur Behandlungsstation (28) und auf die erwähnte flache Oberfläche des Trägers (36) und Mittel, die es ermöglichen, daß der Wafer vom Träger (36) zu einer weiteren Polition herabgleitet.

11. Vorrichtung nach Anspruch 10, wobei der Träger (36) aus seiner Wafer-Aufnahmeposition in eine Positon kippbar ist, wo er die Linie des Ionenstrahls (14) unterbricht.

**Revendications**

1. Un procédé de traitement d'un article dans une chambre sous vide à une pression inférieure à la pression atmosphérique, comprenant les étapes qui consistent à positionner l'article à l'intérieur de la chambre sous vide sur un support (36) dans une station de traitement (28) et à introduire un gaz entre l'article et le support, lequel gaz conduit la chaleur entre l'article et le support, caractérisé par le contrôle de la température de l'article pendant le traitement, grâce à l'introduction dudit gaz conducteur de chaleur directement entre l'article et le support, à une pression prédéterminée supérieure à la pression inférieure à la pression atmosphérique qui règne dans la chambre sous vide, tout en fixant l'article sur le support pour limiter l'écoulement de gaz en excès et produire un trajet de conduction thermique de faible longueur.

2. Un procédé tel que revendiqué dans la revendication 1, dans lequel le gaz conducteur de chaleur est introduit entre l'article et le support à une pression de 0,5 à 2,0 torrs (66,661 et 266,644 N/m²).

3. Un procédé tel que revendiqué dans la revendication 1 ou 2, pour l'implantation d'ions dans une tranche de semiconducteur, le procédé comportant les étapes qui consistent à diriger un faisceau ionique vers la tranche à la station de traitement pour implanter des ions dans la tranche et à évacuer la chaleur de la tranche jusqu'au support par l'intermédiaire du gaz conducteur de chaleur.

4. Un procédé tel que revendiqué dans la revendication 1, 2 ou 3, comprenant l'étape qui consiste à refroidir le support de façon à refroidir l'article qui est traité par conduction de la chaleur de l'article au support par l'intermédiaire du gaz conducteur de chaleur.

5. Un appareil pour manipuler et traiter des objets sous vide au moyen d'un procédé tel que revendiqué dans la revendication 1 ou 2, comprenant une chambre à vide (17), une station d'introduction (26), une station de traitement (28), une station de sortie (32), un support (36) ayant une surface de montage sensiblement plate sur laquelle un article doit être fixé à la station de traitement, une source de gaz sous pression (44, 45), des moyens de régulation (45) pour contrôler la pression de gaz fourni par la source, et des moyens formant conduit (36') raccordés à ladite source, débouchant au niveau d'un orifice situé sur la surface de montage plate du support pour introduire le gaz sous pression, contrôlée directement entre l'article fixé à la station de traitement et le support (36) afin de conduire la chaleur entre l'article et le support.

6. Un appareil tel que revendiqué dans la revendication 5, comprenant un joint d'étanchéité (47) pour adapter de manière étanche un article à traiter sur le support au voisinage de la périphérie de l'article, l'article étant positionné au-dessus de l'orifice.

7. Un appareil tel que revendiqué dans l'une quelconque des revendications 5 ou 6 pour traiter une tranche de semiconducteur afin d'y implanter des ions par un procédé tel que revendiqué dans la revendication 3, l'appareil comportant une source (11) d'ions et une colonne (13) d'accélération des ions pour diriger un faisceau ionique vers une tranche disposée dans la station de traitement.

8. Un appareil tel que revendiqué dans l'une quelconque des revendications 5 à 7 pour traiter un article sous vide par un procédé tel que revendiqué dans la revendication 4, comportant un système de refroidissement (36", 42) pour refroidir le support (36).

9. Un appareil tel que revendiqué dans la revendication 7, comprenant des moyens pour contrôler la température de la surface de montage, un organe de serrage (43) pourvu d'une ouverture centrale pour venir en prise avec une surface plane d'une tranche de semi-conducteur au niveau de sa périphérie pour fixer l'autre surface plane de la tranche contre la surface de montage, ladite colonne d'accélération des ions étant dirigée à travers l'ouverture (43') de l'organe de serrage vers la surface première nommée de ladite tranche.

10. Un appareil tel que revendiqué dans la revendication 9, comprenant des moyens pour amener par gravité la tranche à partir d'une première position à la station de traitement (28) et sur ladite surface plane du support (36) et des moyens permettant à la tranche de glisser à partir du support (36) vers une autre position.

11. Un appareil tel que revendiqué dans la revendication 10, dans lequel le support (36) est pivotable, de sa position de réception de tranche, vers une position dans laquelle il intercepte la ligne du faisceau d'ions (14).

FIG. 1

FIG. 2

FIG. 3

FIG.4

FIG. 5

thermal
conductivity

6

5

4

3

2

1

gas pressure (μm Hg)

10   100   1000  5000

(5000 μm Hg = 666.61 N/m²)

°C

200

100

0

.5      1.0      1.5      2.0

N₂
800 μ m Hg

N₂
1500 μ m Hg

N/cm²

FIG. 6

2